# EUROPEAN PATENT APPLICATION

(11) **EP 3 554 190 A1**
(43) Date of publication of application: **16.10.2019**
(21) Application number: 18178124.6
(22) Date of filing: 15.06.2018
(51) Int. Cl.: H05B 3/00, H05B 1/02, A24F 47/00

(54) **AN ELECTRONIC HEATING CONTROL SYSTEM, ELECTRONIC HEATING DEVICE AND CONTROL METHOD THEREOF**

(30) Priority: 13.04.2018 CN 201810332058
(71) Applicant: Shenzhen Hangsen Star Technology Co., Ltd., Shenzhen, Guangdong 518112 (CN)
(72) Inventor: YAO, Haofeng, Shenzhen, Guangdong 518112 (CN); ZHANG, Shipeng, Shenzhen, Guangdong 518112 (CN); MA, Fangshuo, Shenzhen, Guangdong 518112 (CN)
(74) Representative: Poskett, Oliver James

(57) **Abstract**

The invention relates to an electronic heating control system, electronic heating device and control method thereof. The electronic heating control system comprises a power control module, a current detection module, and a voltage detection module. The input of the power control module is connected to an energy source, and the output of the power control module is connected to the input of the current detection module. The control end of the power control module connects an external control signal. The output end of the current detection module is connected to the input end of the voltage detection module. The output end of the current detection module is connected to a heater. The invention adopts a ceramic heating pipe distributed heating elements which can be arranged side by side on the ceramic heating pipe, the heating elements adopt interval heating, easy assembly, and low production difficulty.

## Description

### Technical Field

The invention relates to the electronic heating device manufacturing field, especially for an electronic heating control system, electronic heating device and control method thereof.

### Background Art

The low-temperature and non-burning baked smoking device, i.e., electronic heating devices is a new type of cigarette smoking apparatus, which is popular because the working temperature is far less than the temperature of direct burning of cigarettes.

The existing low-temperature and non-burning roasted smoking devices are heated in the following manners: 1. The intermediate insertion type heating rod can only be a single-stage heating, and the smoke bomb has a special shape, the heating effect is not good, and it is not convenient for the general market Insertion of cigarettes; 2. The use of an integral heat pipe, which has a poor heating effect and cannot be controlled at a constant temperature; 3. The copper pipe winding method is used to generate heat, which is inconvenient to assemble and is difficult to produce.

### Summary of the Invention

The invention relates to an electronic heating control system, electronic heating device and control method thereof. The electronic heating control system comprises a power control module, a current detection module, and a voltage detection module. The input of the power control module is connected to an energy source, and the output of the power control module is connected to the input of the current detection module. The control end of the power control module connects an external control signal. The output end of the current detection module is connected to the input end of the voltage detection module. The output end of the current detection module is connected to a heater. The invention adopts a ceramic heating pipe distributed heating elements which can be arranged side by side on the ceramic heating pipe, the heating elements adopt interval heating, easy assembly, and low production difficulty. The heating elements adopt a differential amplifying circuit to realize current detection and achieve a constant temperature effect. The ceramic heating pipe is cylindrical type, which is more suitable for common cigarettes on the market. The heating elements adopt segmented baking, and make the heating effect better.

The purpose of the present invention is to overcome the drawbacks of the prior art and provide an electronic heating control system, an electronic heating device and a control method thereof.

The invention provides an electronic heating control system, which comprises a power control module, a current detection module, and a voltage detection module, wherein:
the input of the power control module is connected to an energy source, and the output of the power control module is connected to the input of the current detection module, and the control end of the power control module connects a external control signal;
the output end of the current detection module is connected to the input end of the voltage detection module; and
the output end of the current detection module is also connected to a heater.

Its further technical solution is the following:
the power control module comprises a driving chip Q1 and a switching transistor Q2; wherein:
the power control module is connected to the energy source through the input end of the driving chip Q1, and the power control module is connected to the input end of the current detection module through the output end of the driving chip Q1; and
the control end of the driver chip Q1 is connected to the input end of the switching transistor Q2, and the control end of the switching transistor Q2 is connected to an external control signal, and the output end of the switching transistor Q2 is grounded.

Its further technical solution is the following:
a first current limiting resistor R6 is also connected between the control end of the driving chip Q1 and the input end of the switching transistor Q2, and a pull-up resistor R3 is connected in parallel between the input end of the driving chip Q1 and a connection point formed between the input end of the switching transistor Q2 and the first current limiting resistor R6.

Its further technical solution is the following:
a delay capacitor C5 is connected between the ground and a connection point formed between the control end of the driving chip Q1 and the first current limiting resistor R6.

Its further technical solution is the following:
the current detection module comprises a differential amplifier U2, a current sampling resistor R1, and a third current limiting resistor R11, wherein:
the current detection module is connected to the output end of the driving chip Q1 through one end of the current sampling resistor R1, and the current detection module is connected to the input end of the voltage detection module through the other end of the current sampling resistor R1; and
two current sampling pins of the differential amplifier U2 are respectively connected in parallel at both ends of the current sampling resistor R1, and the output end of the differential amplifier U2 outputs a voltage signal through the third current limiting resistor R11, and the output end of the third current limiting resistor R11 is grounded through the filter capacitor C7.

Its further technical solution is the following:
the voltage detection module comprises a first voltage divider resistor R5 and a second voltage divider resistor R7; wherein:
the voltage detection module is connected to the current sampling resistor R1 through one end of the first voltage divider resistor R5, and the other end of the voltage dividing resistor R5 is connected to the end of the second voltage dividing resistor R7, and the other end of the second voltage dividing resistor R7 is grounded; the connection point between the first voltage dividing resistor R5 and the second voltage dividing resistor R7 is a voltage detection point.

Its further technical solution is the following:
the connection point formed between one end of the first voltage divider resistor R5 and the current sampling resistor R1 is grounded through a discharge resistor R4.
the purpose of the present invention also provides an electronic heating device, which comprises the above-mentioned electronic heating control system, a heater and a ceramic heating pipe; wherein the heater is disposed on a ceramic heating pipe, and the electronic heating system is electrically connected with the heater.

Its further technical solution is the following:
at least two electronic heating control systems are comprised in the electronic heating device; accordingly, the heater comprises at least two heating elements, and the number of both the heating elements and the electronic heating control systems is the same.

The purpose of the present invention also provides a heating control method, which comprises:
powering on and initializing;
the electronic heating control system controls the heater to start heating;
according to the metal compound coating disposed on the ceramic heating pipe, and combining with the RTC curve of the metal compound coating, calculating the temperature of the location of the heater on the ceramic heating pipe.

The beneficial effect of the present invention, as the following:
A differential amplifier circuit is used for the heater on the ceramic heating tube to realize current detection and reach a constant-temperature effect. The ceramic heating tube is a cylinder type, which is more suitable for common cigarettes on the market; sectional baking has better heating effect.

If there are multiple sets of heat generating elements, they can be placed on the ceramic heating tube at intervals, and the heating effect can be achieved by sequentially heating the heat generating element and simulating the combustion state of the cigarette.

### Description of Drawings

FIG.1 is the circuit block diagram of an electronic heating control system.
FIG.2 is the electronic circuit diagram of an electronic heating control system.
FIG.3 is the electronic circuit diagram of a control unit.
FIG.4 is the structural of the ceramic heating tube.
FIG.5 is the flow chart of heating control method of electronic heating device.
FIG.6 is the RTC curve of metal compound coating on the surface of the ceramic heating tube.

### Detailed Description of the Invention

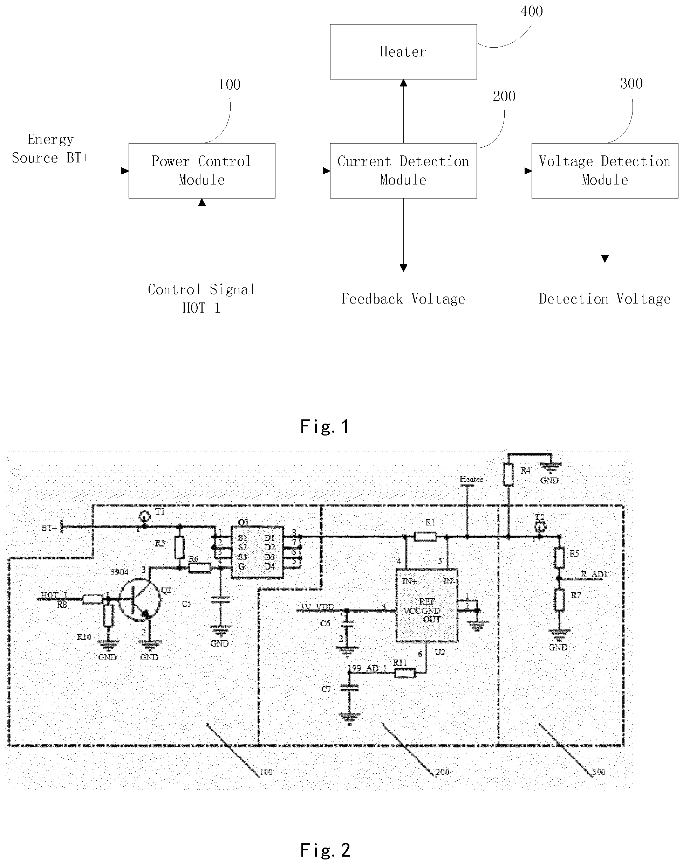

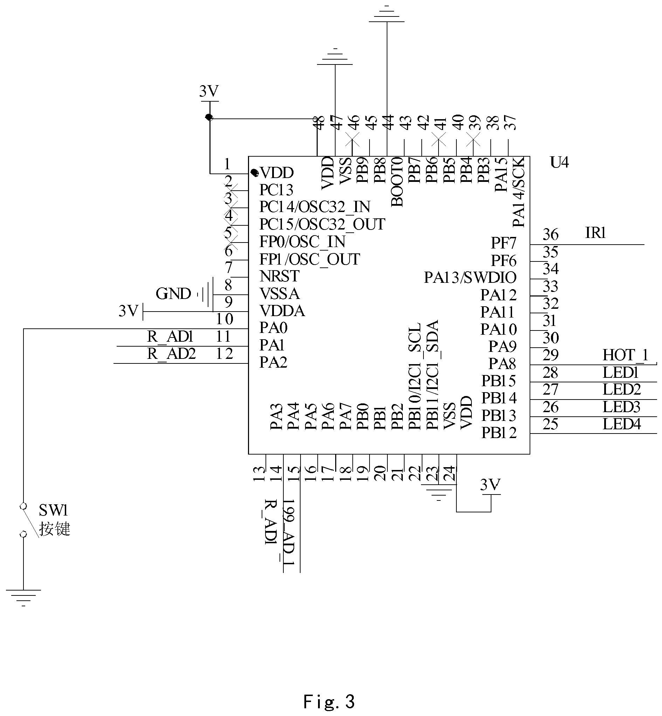

As shown in Fig.1 to Fig.3, An electronic heating control system provided by the present invention comprises a power control module 100, a current detection module 200, and a voltage detection module 300; wherein the input of the power control module 100 is connected to an energy source BT+, and the output of the power control module 100 is connected to the input of the current detection module 200, and the control end of the power control module 100 connects the external control signal, and the output of the current detection module 200 is electrically connected to the input of the voltage detection module 300, and then the output end of the current detection module 200 is also connected to heater 400; wherein the control signal HOT_1 externally connected to the control end of the power control module 100 is provided by a control chip U4 of the control unit.

Specifically, as shown in FIG. 2, the power control module 100 comprises a driving chip Q1 and a switching transistor Q2. The switching transistor Q2 is turned on or off in the control signal HOT_1, and the switching transistor Q2 controls the driving chip Q1 to drive the heater 400 heating or no.

The power control module 100 is electrically connected to the energy source BT+ through the input end of the driving chip Q1. The power control module 100 is electrically connected to the input end of the current detection module 200 through the output end of the driving chip Q1. The control end of the driving chip Q1 and the input end of the switching transistor Q2 is electrically connected, and the control end of the switching transistor Q2 is connected to an external control signal HOT_1, and the output end of the switching transistor Q2 is grounded. Wherein, the input end of the driving chip Q1 acts as the input end of the power control module 100, that is the input end of the energy source BT+. The enable end of the switching transistor Q2 acts as a control end of the power control module 100, and inputs the control signal HOT_1. The output end of the driving chip Q1 acts as the output of the power control module 100.

In this embodiment, the energy source BT+ is a rechargeable battery, such as a high-polymer rechargeable battery, a lithium battery, a nickel hydrogen battery, a grapheme battery, and the like.

The switching transistor Q2 may be a transistor, a MOS transistor, a SCR three-terminal switch transistor, etc. In this embodiment, it is a PNP transistor, such as P-MOS transistor.

The above-mentioned driving chip Q1 is a P-MOS transistor. According to the characteristics of the P-MOS transistor when the voltage Vgs between the gate and the source is smaller than a certain value that is 0.8v∼2.0v, the P-MOS transistor is turned on; otherwise, it is turned off.

A first current limiting resistor R6 is connected in between the control end (gate, G pole) of the driving chip Q1 and the input tend (collector, C pole) of the switching transistor Q2. A pull-up resistor R3 is connected in parallel between the input end (source, S pole) of the driving chip Q1 and the connection point formed between the input end of the switching transistor Q2 (collector, C pole) and the first current-limiting resistor R6. Wherein, the pull-up resistor R3 is configured to stably drive the control end of the chip Q1 to a high level, and when the switch Q2 is turned on, the first current limiting resistor R6 can reduce the current flowing through the switching transistor Q2. So as to avoid damage the switching transistor Q2 and (or) the driving chip Q1.

The above-mentioned driving chip Q1 may also be an N-MOS transistor in other embodiments.

Further, the connection point formed between the control end of the driving chip Q1 and the first current limiting resistor R6 is grounded through a delay capacitor C5, which can delay the discharge when the switching transistor Q2 is turned off and release the parasitic voltage in the circuit.

Wherein, the working principle of the driving chip Q1 and the switching transistor Q2 is following:
When control signal HOT_1 outputs a low level, the switching transistor Q2 turns off and the control terminal (gate, G pole) of the driving chip Q1 is high level, and the input end (source, S pole) and the output end (drain, D pole) of the driving chip Q1 turn off. At this time, the driving chip Q1 stops working, and the driving chip Q1 does not provide working current to the heater 400, and the heater 400 does not generate heat.

When the control signal HOT_1 is high level, the switching transistor Q2 turns on. The control end of the driving chip Q1 is a low level, and the input end (source, S-pole) and the output end (drain, D-pole) of the driving chip Q1 turn on, then the driving chip Q1 provides working current to the heater 400,and the heater heats.

As shown in FIG. 2, the current detection module 200 comprises a differential amplifier U2, a current sampling resistor R1, and a third current limiting resistor R11. The current detection module 200 is electrically connected to the output end of the driving chip Q1 through one end of the current sampling resistor R1. The module 200 is electrically connected to the input end of the voltage detection module 300 through the other end of the current sampling resistor R1, and the connection point is externally connected to the heating element 400. Two current sampling pins of the differential amplifier U2 are respectively connected in parallel at both ends of the current sampling resistor R1. The output end of the differential amplifier U2 outputs a voltage signal through the third current limiting resistor R11, and the output end of the third current limiting resistor R11 is grounded through a filter capacitor C7. Wherein, the filter capacitor C7 acts as anti-interference.

Since the heater 400 is connected to the current output end of the current sampling resistor R1 and both sampling ends of the different amplifier U2 are respectively connected in parallel between two ends of the current sampling resistor R1, the differential amplifier U2 can sample the voltage of the heater 400 when the current flow through the sampling resistor R1, and the differential amplifier U2 obtain a sample voltage. After the sample voltage pass through the current amplification of the differential the amplifier U2, the current limiting of the third current limiting resistor R11 and the capacitance filtering of the filter capacitor C7, a feedback voltage is output to the control chip U4 from the voltage output end 199_AD1 of the differential amplifier U2, and the control chip U4 outputs the control signal HOT_1 to the switching element Q2.

As shown in FIG. 2, the voltage detection module 300 comprises a first voltage divider resistor R5 and a second voltage divider resistor R7. The voltage detection module is electrically connected to the current sampling resistor R1 through one end of the first voltage divider resistor R5. The other end of the voltage resistor R5 is electrically connected to one end of the second voltage divider resistor R7, and the other end of the second voltage divider resistor R7 is grounded; the connection point formed between the first voltage divider resistor R5 and the second voltage divider resistor R7 is voltage detection point. Wherein, the first voltage dividing resistor R5 and the second voltage dividing resistor R7 are mainly configured to provide a detection voltage during the voltage detection. At the same time, when the voltage of the heater 400 is too high, the voltage at both ends of the heater 400 will be reduced.

Further, a connection point formed between one end of the first voltage dividing resistor R5 and the current sampling resistor R1 is grounded through a discharge resistor R4. The discharge resistor R4 is configured to release the parasitic current in the circuit after the circuit is powered off and is configured to remove the effect of the capacitance in the line.

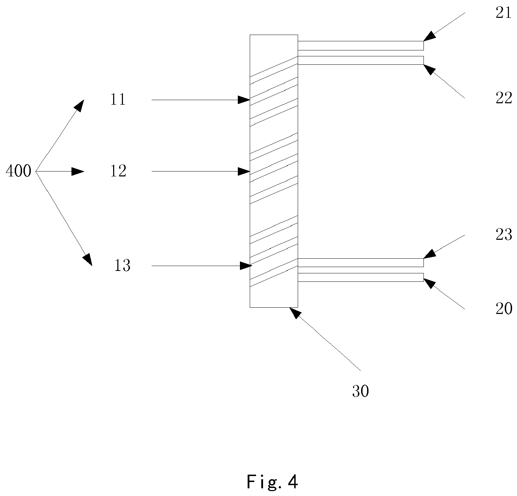

Specifically, the present invention also discloses an electronic heating device, which comprises the above-mentioned electronic heating control system, a heater 400, and a ceramic heating pipe 30. The heater 400 is disposed on the ceramic heating pipe 30, preferably the heater is disposed on the ceramic heating pipe 30 by winding method, as shown in Fig.4. The electronic heating control system is electrically connected to the heater 400, wherein the surface of the ceramic heating tube 30 is coated with a coating, which may be a metal compound coating, whose material can be alumina, zirconia, aluminum nitride, etc., preferably aluminum oxide; the thickness of the metal compound coating 20nm-100nm.

The electronic heating device comprises at least two electronic heating control systems, accordingly, the heater 400 comprises at least two heating elements, and each heating control system corresponds to a heating element, i.e., the number of heating element is consistent with the number of the electronic heating control system.

As shown in FIG. 4, in the present embodiment, the electronic heating device comprises three electronic heating control systems, and the heater 400 comprises three heating elements, wherein the ceramic heating tube 30 is a hollow cylindrical structure. The heater 400 is nickel-chromium heating wire. The heater 400 is wound on the surface of the ceramic heating tube 30 in three segments independently, and the three segments heater form three independent heating elements (11, 12, and13). The three heating elements (11, 12, and13) each correspond to three control ends (21, 22, and 23) and share a common end 20. The three control end (21, 22, and 23) respectively connects with the three electronic heating control systems, and the common end 20 is connected with the three electronic heating control systems. Three heating elements (11, 12, and 13) are controlled by respective control electronic heating control systems by three control ends (21, 22, and 23). Wherein, the heater 400 comprising three heating elements (11, 12, and 13) is correspond to the first heating element 11, the second heating element 12, and the third heating element 13 respectively. And the three control ends (21, 22, and 23) are the first heating element control end 21, the second heating element control end 22 and the third heating element control end 23 respectively. Each lengths of the three heating elements (11, 12, and 13) on the surface of the ceramic heating pipe 30 may be the same or different, and the respective resistance values of the three heating elements (11, 12, and 13) may be the same or different, and those depends on the needs the device.

When in use, a cigarette or tobacco is placed in the hollow cavity of the ceramic heating pipe 30, and according to the packing height of the cigarette or tobacco in the hollow cavity of the ceramic heating tube 30, three electronic heating control systems respectively control three heating elements (11, 12, and 13) independent heating or combine heating, etc., so as to ensure energy saving and provide users with a good sense of taste.

Wherein, the operation and detection principle of the heating element is as follows (taking the first heating element 11 as an example):
after the energy passes through the current sampling resistor R1 and the first heating element 11, the voltage passing the current sampling resistor R1 is detected by the differential amplifier U2;
according to I=U/R, the current passing the first heating element 11 is calculated;
according to the voltage detection module 300 obtains the detection voltage, the resistance of the first heating element 11 is calculated by R=U/I;
according to the RTC curve of the first heating element 11 corresponding to the metal compound coating at the position of the ceramic heating pipe 30, the temperature of the first heating element 11 corresponding to the current ceramic heating pipe section is obtained.

Wherein, the temperature detection principle of the second heating element 12 and the third heating element 13 is the same as the first heating element r 11.

The electronic heating device detects the temperature data on the corresponding ceramic heating pipe through the above three heating elements and controls the energy output of each heating elements to realize the intelligent control of the constant-temperature and step-by-step progressive heating modes.

The purpose of the present invention also provides a heating control method, which comprises the following step:
Step 1, powering on and initializing;
Step2, the electronic heating control system controlling the heater to start heating;
Step 3, according to the metal compound coating disposed on the ceramic heating pipe and combining with the RTC curve of the metal compound coating, and calculating the temperature of the location of the heater on the ceramic heating pipe.

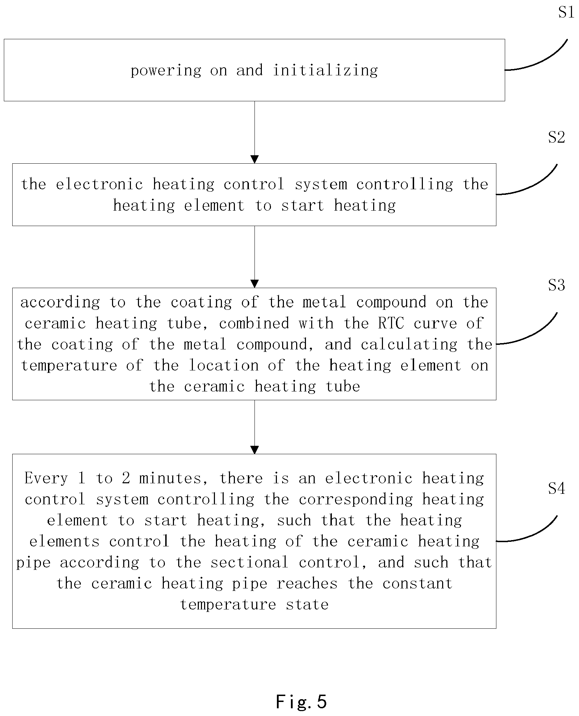

As shown in Fig.5, When the electronic heating device comprises more than two heating control systems, and each heating control system corresponds to one of the heating elements, wherein the heating control method flow is as follows:
Step 1', powering on and initializing;
Step 2', the electronic heating control system controlling the heating element to start heating;
Step 3', according to the metal compound coating disposed on the ceramic heating pipe, and combining with the RTC curve of the metal compound coating, and calculating the temperature of the location of the heating element on the ceramic heating pipe ;
Step 4', every 1 to 2 minutes, there is an electronic heating control system controlling the corresponding heating element to heat, such that the heating elements control the heating of the ceramic heating pipe according to the sectional control, and such that the ceramic heating pipe reaches the constant temperature state.

In this method, when the number of heating elements is two or more, in order to avoid ambiguity, the adjustment of the "heater" at this time comprises a plurality of "heating elements", that is, the heater comprises multiple heating elements; When the number of heating control systems and the number of heater is only one, the heater at this time is a heating element.

Wherein, the principle of RTC curves of ceramic heating pipe is the following:
The metal compound coating on the surface of the ceramic heating pipe 30 is heated by the heater 400. The resistance of the metal compound coating changes with the temperature, and the temperature is proportional to the resistance. When the resistance value of the metal compound coating is calculated, the heating temperature of the heater can be calculated.

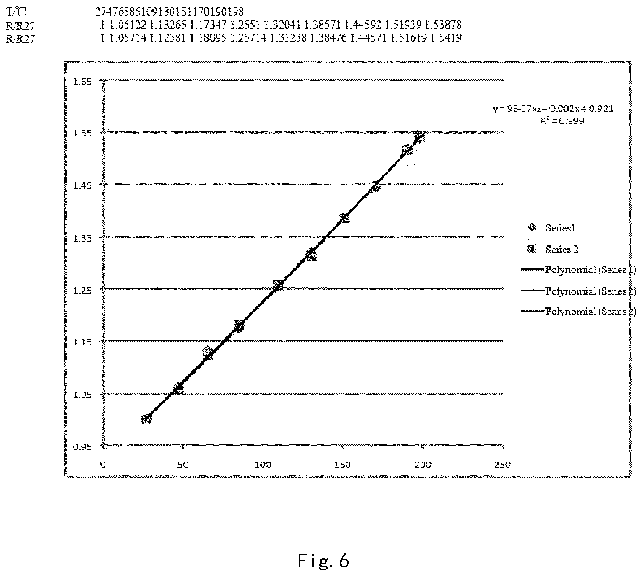

As shown in FIG. 6, there is the RTC curve of the metal compound coating on the surface of the ceramic heat-generating tube 30, wherein X-axis of abscissa is temperature, and Y-axis of ordinate is resistance. According to the curve of the temperature and the resistance, the corresponding temperature of the heater can be calculated.

The working principle of the invention is the following:
Through the button SW1 to open, and the ceramic heating pipe is heated by the electronic heating control system controlling the heater. According to the metal compound coating of the ceramic heating pipe in the heating process, and combining with the RTC curve, and the resistance value of the heater (or heating element) can be calculated, and the heating temperature of the heater (or heating elements) can be calculated, In order to achieve a constant temperature effect.

The heating process simulates the combustion mode of a common cigarette, and heating is performed from the first heating element. After a certain period of time, that is 1 minute to 2 minutes, the second the heating monomer is heated, and after 1 minute to 2 minutes, the third heating element is heated, so that the ceramic heating pipe is heated step by step, and the cigarette or tobacco baking outlet feels better cigarette smoke.

In summary, the present invention adopts a heating element composed of three sections of heating elements distributed on a ceramic heating pipe, which is separated and independently heated to facilitate assembly, and the production difficulty is low; the heating element uses a differential amplifier for current detection to achieve a constant temperature effect. The ceramic heating tube is a hollow cylinder, which is more suitable for common cigarettes on the market; and the stepwise baking makes the heating effect better.

## Claims

1. An electronic heating control system, comprising a power control module, a current detection module, and a voltage detection module wherein:
the input of the power control module is connected to an energy source, and the output of the power control module is connected to the input of the current detection module;
the control end of the power control module connects an external control signal;
the output end of the current detection module is connected to the input end of the voltage detection module; and
the output end of the current detection module is also connected to a heater.

2. The electronic heating control system of claim 1, wherein the power control module comprises a driving chip (Q1) and a switching transistor (Q2) wherein:
the power control module is connected to the energy source through the input end of the driving chip (Q1), and the power control module is connected to the input end of the current detection module through the output end of the driving chip (Q1); and
the control end of the driver chip (Q1) is connected to the input end of the switching transistor (Q2), and the control end of the switching transistor (Q2) is connected to an external control signal, and the output end of the switching transistor (Q2) is grounded.

3. The electronic heating control system of claim 2, wherein a first current limiting resistor (R6) is also connected between the control end of the driving chip (Q1) and the input end of the switching transistor (Q2), and a pull-up resistor (R3) is connected in parallel between the input end of the driving chip (Q1) and a connection point formed between the input end of the switching transistor (Q2) and the first current limiting resistor (R6).

4. The electronic heating control system of claim 3, wherein a delay capacitor (C5) is connected between the ground and a connection point formed between the control end of the driving chip (Q1) and the first current limiting resistor R6.

5. The electronic heating control system of claim 2, wherein the current detection module comprises a differential amplifier (U2), a current sampling resistor (R1), and a third current limiting resistor (R11), wherein:
the current detection module is connected to the output end of the driving chip (Q1) through one end of the current sampling resistor (R1), and the current detection module is connected to the input end of the voltage detection module through the other end of the current sampling resistor (R1); and
two current sampling pins of the differential amplifier (U2) are respectively connected in parallel at both ends of the current sampling resistor (R1), and the output end of the differential amplifier (U2) outputs a voltage signal through the third current limiting resistor (R11), and the output end of the third current limiting resistor (R11) is grounded through the filter capacitor (C7).

6. The electronic heating control system of claim 5, wherein the voltage detection module comprises a first voltage divider resistor (R5) and a second voltage divider resistor (R7) wherein:
the voltage detection module is connected to the current sampling resistor (R1) through one end of the first voltage divider resistor (R5), and the other end of the voltage dividing resistor (R5) is connected to the end of the second voltage dividing resistor (R7), and the other end of the second voltage dividing resistor (R7) is grounded;
the connection point formed between the first voltage dividing resistor (R5) and the second voltage dividing resistor (R7) is a voltage detection point.

7. The electronic heating control system of claim 6, wherein the connection point formed between one end of the first voltage divider resistor (R5) and the current sampling resistor (R1) is grounded through a discharge resistor (R4).

8. An electronic heating device comprising the electronic heating control system of any one of claims 1 to 7, a heater and a ceramic heating pipe; wherein
the heating element is disposed on the ceramic heating pipe, and the electronic heating system is electrically connected with the heater.

9. The electronic heating device of claim 8, comprising at least two electronic heating control systems; wherein, the heater also comprises at least two heating elements, and the number of both the heating elements and the electronic heating control systems is the same.

10. A heating control method using the electronic heating device of claim 9, comprising:
powering on and initializing;
the electronic heating control system controlling the heater to start heating;
according to the metal compound coating disposed on the ceramic heating pipe, and combining with the RTC curve of the metal compound coating, calculating the temperature of the location of the heater disposed on the ceramic heating pipe.

11. The heating control method of claim 10, wherein when the electronic heating device comprises more than two heating control systems, and each heating control system corresponds to one of the heating elements, the heating control method comprises:
powering on and initializing;
the electronic heating control system controlling the heating element to start heating;
according to the metal compound coating coated on the ceramic heating pipe, and combining with the RTC curve of the metal compound coating, calculating the temperature of the location of the heating elements disposed on the ceramic heating pipe;
every 1 to 2 minutes, the electronic heating control system controlling the corresponding heating element to heat such that the heating elements control the heating of the ceramic heating pipe according to the sectional control and such that the ceramic heating pipe reaches a constant temperature state.
